# EUROPÄISCHE PATENTANMELDUNG

(11) **EP 1 970 157 A1**
(43) Veröffentlichungstag der Anmeldung: **17.09.2008**
(21) Anmeldenummer: 07005302.0
(22) Anmeldetag: 14.03.2007
(51) Int. Cl.: B23P 6/00

(54) **Verfahren zur Reparatur eines Bauteils**

(71) Anmelder: SIEMENS AKTIENGESELLSCHAFT, 80333 München (DE)
(72) Erfinder: Bagaviev, Albert, Dr., 45470 Mühlheim an der Ruhr (DE); Barnikel, Jochen, Dr., 45470 Mühlheim an der Ruhr (DE); Pan, Ying, Dr., 45219 Essen (DE); Schmitz, Friedhelm, 46537 Dinslaken (DE); Siegel, Michael, 46487 Wesel (DE)

(57) **Zusammenfassung**

Die Erfindung betrifft ein Verfahren zur Reparatur eines Bauteils (1), insbesondere Dampfturbinenbauteil, insbesondere Innengehäuse bzw. Außengehäuse sowie einen Ventilkörper (1) einer Dampfturbine.

Das erfindungsgemäße Verfahren zeichnet sich dadurch aus, dass über einer Schädigung (7) auf dem Bauteil (1) eine Schutzschicht aufgetragen wird, wobei die Schutzschicht auf einer eisenbasierten Legierung basiert und auf dieser eisenbasierten Haftschicht eine Wärmedämmschicht aufgebracht wird, wodurch die thermischen Einflüsse minimiert werden und damit eine Gefügeschädigung, Rissbildung und fortschritt gehemmt wird.

## Beschreibung

Die Erfindung betrifft ein Verfahren zur Reparatur eines Bauteils, wobei das Bauteil eine Schädigung aufweist.

In manchen Turbinenkomponenten, insbesondere Dampfturbinenkomponenten, wie z. B. Ventilkörper oder Turbinengehäuse, können lokale Schädigungen auftreten. Oft ist eine Reparatur des geschädigten Bauteils nicht möglich. In manchen Fällen ist in einem vertretbaren Zeitrahmen ein Austausch der geschädigten Komponente möglich. Um dennoch das geschädigte Bauteil weiter zu betreiben, ist es möglich, eine Lebensdaueranalyse durchzuführen, wobei das Ziel solch einer Analyse es ist, herauszufinden, wie lang das betreffende Bauteil bis zum Bauteilversagen betrieben werden kann. Ein somit betriebener Turbosatz umfassend die beschädigte Komponente könnte demnach maximal bis zum kalkulierten Bauteilversagenszeitpunkt sicher betrieben werden.

Wünschenswert wäre es, geschädigte Bauteile weiter sicher betreiben zu können.

An dieser Stelle setzt die Erfindung an, deren Aufgabe es ist, ein Verfahren zur Reparatur eines Bauteils anzugeben, das ein Weiterbetreiben des Bauteils dadurch ermöglicht, dass ein endgültige Reparatur oder ein endgültiger Austausch der Komponenten in einer günstig geplanten Revision durchgeführt werden kann. Für den Fall, dass ein Austausch der Komponenten nötig ist, kann die Zeit für die Bestellung der Gussteile überbrückt werden.

Gelöst wird dies durch ein Verfahren zur Reparatur eines Bauteils, wobei das Bauteil eine Schädigung aufweist, wobei über der Schädigung eine Schutzschicht aufgebracht wird.

Die Erfindung geht von dem Gedanken aus, dass durch die Anwendung einer Schutzschicht die darunter liegende Werkstoff vor störenden Temperaturgradient geschützt wird. Eine unter solcher Schutzschicht zu findende Schädigung des Bauteils wäre dadurch vor störenden Temperaturschwankungen geschützt, was eine Vergrößerung der Schädigung verlangsamen würde. Oftmals sind solche Gefügeschädigungen oder Risse vorzufinden. Solche Schädigungen würden im Falle einer aufgetragenen Schutzschicht sich sehr langsam vergrößern, da Temperaturgradienten, die zu thermischen Spannungen im Bauteil und dadurch zu einer weiteren Gefügeschädigungen führen, reduziert werden.

Vorteilhaft wird die Schutzschicht über die Schädigung aufgebracht. Die Schädigung kann hierbei ein Riss sein, der von der Bauteiloberfläche eine Risstiefe lang in das Bauteil ragt. Es wird daher keine großflächige Oberfläche der Schädigung mit einer Schutzschicht versehen, sondern lediglich auf der Bauteiloberfläche.

Vorteilhafterweise weist diese Schutzschicht eine eisen-, nickel- und kobaltbasierte Legierung auf, wobei auf die eisenbasierte Legierung eine Wärmedämmschicht aufgebracht wird.

Die so genannten Wärmedämmschichten sind aus dem Gasturbinenbau bekannt. Insbesondere sind keramische Wärmedämmschichten, umfassend Zirkonoxid oder Titanoxid, bekannt und werden häufig eingesetzt. Die eisen-, nickel- und kobaltbasierte Legierung wirkt als Haftschicht, die eine Verbindung zwischen der Oberfläche des Bauteils und der Wärmedämmschicht hervorbringt. Die Haftschicht sollte eine angemessene Duktilität aufweisen, insbesondere sollte die Duktilität im hier verwendeten Verfahren größer sein als die im Gasturbinenbau üblich verwendete Duktilität.

Die Gefügeschädigung wird dadurch verlangsamt oder sogar gestoppt, weil die Wärmedämmschicht den Temperaturgradienten des Bauteils verringert und dadurch die Wärmespannung, insbesondere beim An- und Abfahren eine geringere Auswirkung auf das Bauteil aufweisen.

Die Erfindung zeigt daher den Vorteil, dass die Lebensdauer des Bauteils verlängert werden kann.

Vorteilhafterweise wird die Wärmedämmschicht mit einer Dicke von 100µm und 2 mm aufgetragen.

In einer bevorzugten Weiterbildung wird auf die Wärmedämmschicht noch zusätzlich eine Erosionsschutzschicht aufgebracht.

Die Erfindung wird anhand eines Ausführungsbeispiels näher erläutert.

Dabei zeigen:
- Figur 1: Ventilkörper für eine Dampfturbine,
- Figur 2: vergrößerte Darstellung eines Ausschnitts aus Figur 1,
- Figur 3: graphische Darstellung.

Bauteile, die eine Schädigung aufweisen können, sind beispielsweise innere oder äußere Gehäuse einer Hochdruck- bzw. Mitteldruck-Teilturbine sowie Ventilkörper für eine Dampfturbine. Hochdruck- bzw. Mitteldruck-Teilturbinen sowie dafür eingesetzte Ventilkörper werden werkstoffabhängig bis zu 620°C und 300 bar thermo-mechanisch belastet. Wenn eine lokale Schädigung in einem der vorgenannten Bauteile auftritt, führen dynamische und statische thermo-mechanische Beanspruchungen zu einer Vergrößerung dieser Schädigung, was unerwünscht ist. Eine Ausbreitung solch einer Schädigung sollte daher vermieden werden. Solch eine Ausbreitung einer Schädigung wird vermieden, indem ein Verfahren zur Reparatur dieses Bauteils angewendet wird, wobei das Bauteil eine Schädigung aufweist, wobei über der Schädigung eine Schutzschicht aufgebracht wird. Diese Schutzschicht kann eine eisenbasierte Legierung aufweisen. In einer alternativen Ausführungsform ist auf die eisenbasierte Legierung eine Wärmedämmschicht aufgebracht.

Die Wärmedämmschicht ist ein Werkstoff mit schlechter Wärmeleitfähigkeit wie, z.B. Keramiken, Quasikristalle, die beispielsweise zumindest teilweise aus Zirkonoxid, das teilstabilisiert oder vollstabilisiert durch Yttriumoxid und/oder Magnesiumoxid vorliegt und/oder zumindest teilweise aus Titanoxid besteht und beispielsweise dicker als 0,1 mm bis 2 mm ist. So können Wärmedämmschichten, die zu 100% entweder aus Zirkonoxid oder Titanoxid bestehen, verwendet werden. Das Bauteil ist aus einem Grundwerkstoff ausgebildet. Dieser Grundwerkstoff ist beispielsweise ein Substrat und besteht beispielsweise aus einer stahl- oder einer sonstigen eisenbasierten Legierung (beispielsweise 1% CrMoV oder 10% - 12% Chromstähle) oder einer nickel- oder kobaltbasierten Superlegierung, z.B. IN 617.

Weitere vorteilhafte Grundwerkstoffe, aus denen das Bauteil besteht, sind:
1% - 2% Cr-Stahl: wie z. B. 30CrMoNiV5-11 oder 23CrMoNiWV8-8 oder G17CrMoV5-10 oder G17CrMo9-10.
Ein weiterer Werkstoff wäre beispielsweise 9% - 10% Cr-Stahl: wie z. B. X12CrMoWVNbN10-1-1 oder GX12CrMoWVNbN10-1-1 oder GXl2CrMoVNbN9-1.

Die Wärmedämmschicht kann mittels bekannter thermischer Spritzverfahren sowie durch chemische oder physikalische Beschichtungsmethoden aufgebracht werden (CVD, PVD).

Die Schutzschicht weist beispielsweise im Wesentlichen folgende Elemente auf:
11,5 Gew.-% bis 20 Gew.-% Chrom,
0,3 Gew.-% 1,5 Gew.-% Silizium,
0,0 Gew.-% bis 1,0 Gew.-% Aluminium,
0,0 Gew.-% bis 0,7 Gew.-% Yttrium und/oder
zumindest ein äquivalentes Metall aus der Gruppe umfassend Skandium und die Elemente der Seltenen Erden,
Rest Eisen, Kobalt und/oder Nickel sowie herstellungsbedingte Verunreinigungen.

Insbesondere besteht die metallische Zwischenschutzschicht 10 aus 12,5 Gew.-% bis 14 Gew.-% Chrom,
0,5 Gew.-% 1,0 Gew.-% Silizium,
0,1 Gew.-% bis 0,5 Gew.-% Aluminium,
0,0 Gew.-% bis 0,7 Gew.-% Yttrium und/oder
zumindest ein äquivalentes Metall aus der Gruppe umfassend Skandium und die Elemente der Seltenen Erden,
Rest Eisen und/oder Kobalt und/oder Nickel sowie herstellungsbedingte Verunreinigungen.

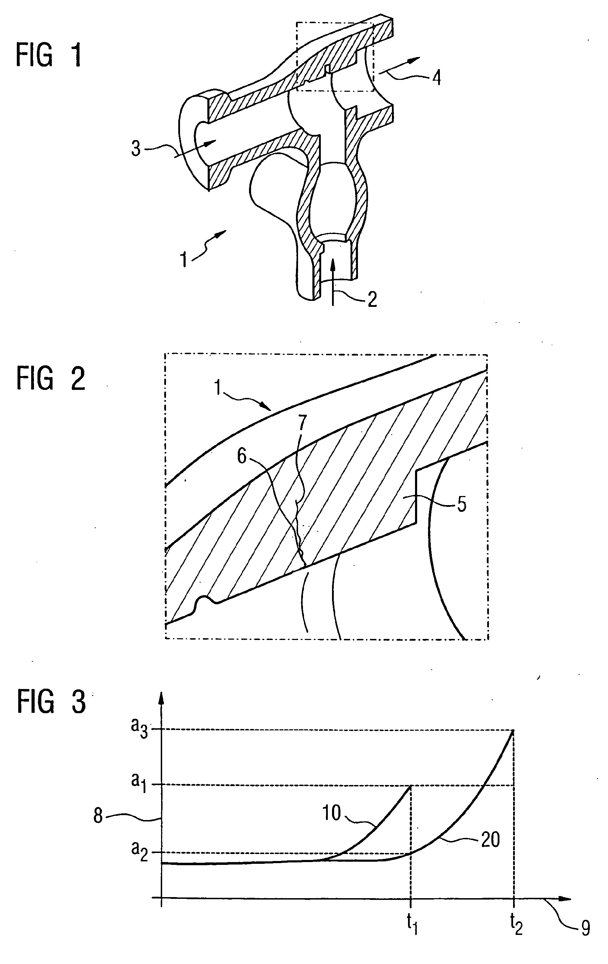

In der Figur 1 ist beispielhaft ein Ventilkörper 1 zum Einsatz im Dampfturbinenbau dargestellt. Der Ventilkörper 1 wird über verschiedene Ein- bzw. Ausgänge 2, 3, 4 mit stark erhitztem Dampf thermisch belastet. Die Temperaturen, die hierbei im Inneren des Ventilkörpers 1 auftauchen können, sind maximal 620°C.

Die Schädigung kann ein Riss oder eine schädliche Gefügeänderung sein. Die Schutzschicht wird über die Schädigung aufgetragen. Gegebenenfalls kann in einem klaffenden Riss oder sonstigen Hohlraum ein weiterer Füllstoff angeordnet werden.

Die Schädigung kann in einer alternativen Ausführungsform komplett mit der Schutzschicht versehen werden. Die Schädigungsoberfläche wird großflächig mit der Schutzschicht versehen. Wichtig ist bei beiden Ausführungsformen, dass das heißes Strömungsmedium nicht auf die Schädigungsoberfläche gelangt.

In der Figur 2 ist beispielhaft eine Innenfläche 5 des Ventilkörpers aus Figur 1 vergrößert dargestellt. An der Stelle 6 können im Betrieb Schädigungen in Form von Rissen auftreten. Durch mehrmaliges zyklisches Aufheizen und Abkühlen kann dieser Riss größer werden, wodurch die Risstiefe vergrößert wird. Durch das erfindungsgemäße Beschichten dieses Bauteils wird das Risswachstum gehemmt.

Die Figur 3 zeigt, wie die Tiefe eines Risses (dargestellt auf der Y-Achse 8) sich im Verlaufe der Zeit (dargestellt auf der X-Achse 9) verhält.

Der Graph 10 zeigt, wie ein Riss mit der Zeit (dargestellt auf der X-Achse 9) verläuft. Deutlich ist zu sehen, dass zu einem Zeitpunkt t₁ die Risstiefe a₁ beträgt. Der Graph 20 zeigt die Rissfortbildung eines Risses mit einer erfindungsgemäß aufgetragenen Schutzschicht über der Schädigung 7. Deutlich ist zu sehen, dass zum Zeitpunkt t₁ die Risstiefe a₂ beträgt, was deutlich niedriger ist als die Risstiefe a₁. Zum späteren Zeitpunkt t₂ beträgt die Risstiefe zwar die Länge a₃, was größer ist als die Länge a₁, allerdings tritt diese Risstiefe erst vergleichsweise sehr spät auf (und zwar zum Zeitpunkt t₂ größer t₁).

## Patentansprüche

1. Verfahren zur Reparatur eines Bauteils (1),
wobei das Bauteil eine Schädigung (7) aufweist,
**dadurch gekennzeichnet, dass**
über der Schädigung (7) eine Schutzschicht aufgebracht wird.

2. Verfahren nach Anspruch 1,
wobei die Schädigung als Gefügeschädigung oder Riss ausgebildet ist und von der Bauteiloberfläche eine Schädigungstiefe lang in das Bauteil ragt
und die Schutzschicht derart über den Schädigung großflächig aufgetragen wird.

3. Verfahren nach Anspruch 1 oder 2,
wobei die Schutzschicht eine eisenbasierte Legierung aufweist.

4. Verfahren nach Anspruch 3,
wobei auf die eisenbasierte Legierung eine Wärmedämmschicht aufgebracht wird.

5. Verfahren nach Anspruch 4,
wobei auf die eisenbasierte Haftschicht eine keramische Wärmedämmschicht aufgebracht wird.

6. Verfahren nach Anspruch 4,
wobei auf die eisenbasierte Haftschicht eine keramische Wärmedämmschicht umfassend Zirkonoxid aufgebracht wird.

7. Verfahren nach Anspruch 4,
wobei auf die eisenbasierte Haftschicht eine keramische Wärmedämmschicht umfassend Titanoxid aufgebracht wird.

8. Verfahren nach einem der Ansprüche 1 bis 7,
wobei die Wärmedämmschicht mit einer Dicke zwischen 100µm und 2 mm aufgebracht wird.

9. Verfahren nach einem der vorhergehenden Ansprüche,
wobei als Bauteil ein Ventilkörper (1) für ein Ventil für eine Dampfturbine verwendet wird.

10. Verfahren nach Anspruch 5,
wobei an der Innenfläche des Ventilkörpers (1) die Schutzschicht aufgebracht wird.

11. Verfahren nach einem der Ansprüche 1 bis 8,
wobei als Bauteil ein Turbinengehäuse einer Dampfturbine verwendet wird.

12. Verfahren nach Anspruch 11,
wobei an der Innenfläche des Turbinengehäuses die Schutzschicht aufgebracht wird.

13. Verfahren nach einem der vorhergehenden Ansprüche,
wobei auf die Wärmedämmschicht eine Erosionsschutzschicht aufgebracht wird.
